# DEMANDE DE BREVET EUROPEEN

(11) **EP 1 406 368 A1**
(43) Date de publication de la demande: **07.04.2004**
(21) Numéro de dépôt: 03292411.0
(22) Date de dépôt: 30.09.2003
(51) Int. Cl.: H02J 7/02, H02J 7/00

(54) **Appareil multimètre à boîtier portable rechargeable par induction**

(30) Priorité: 03.10.2002 FR 0212259
(71) Demandeur: CHAUVIN ARNOUX, 75018 Paris (FR)
(72) Inventeur: Arnoux, Daniel, 44500 La Baule (FR); Arnoux, Axel, 75015 Paris (FR); Genter, Claude, 92200 Neuilly sur Seine (FR)
(74) Mandataire: Berger, Helmut

(57) **Abrégé**

L'invention concerne un appareil multimètre de mesure d'une pluralité de grandeurs, telles que l'intensité ou la tension d'un courant électrique ou la résistance électrique d'un circuit, comprenant un boîtier portable (10) muni d'un accumulateur d'énergie électrique (11) rechargeable.
Selon l'invention, l'appareil comprend des moyens pour charger l'accumulateur (11) par induction.

## Description

L'invention concerne en général les appareils multimètres de mesure d'une pluralité de grandeurs, telles que l'intensité ou la tension d'un courant électrique ou la résistance électrique d'un circuit, et en particulier les appareils multimètres portables.

Plus précisément, l'invention concerne un appareil multimètre comprenant un boîtier portable muni d'un accumulateur d'énergie électrique rechargeable.

Des appareils de ce type sont connus de l'art antérieur et comprennent des accumulateurs amovibles. Quand l'accumulateur est déchargé, l'utilisateur le retire du boîtier, le branche sur le secteur par l'intermédiaire d'un chargeur, et le remet en place dans le boîtier une fois la charge terminée.

Cette opération est contraignante et peu commode pour l'utilisateur. Par ailleurs, elle oblige à séparer l'accumulateur du boîtier portable, l'accumulateur courant alors le risque d'être perdu. La répétition de l'opération de retrait et de remise en place de l'accumulateur dans le boîtier conduit également inévitablement à une dégradation du boîtier à terme.

Dans ce contexte, la présente invention a pour but de pallier les défauts mentionnés ci-dessus.

A cette fin, l'appareil de l'invention, par ailleurs conforme à la définition générique qu'en donne le préambule ci-dessus, est essentiellement caractérisé en ce que qu'il comprend des moyens pour charger l'accumulateur par induction.

Dans un mode de réalisation possible de l'invention, l'appareil comprend un socle présentant un logement de réception du boîtier portable, les moyens pour charger l'accumulateur comprenant un dispositif de gestion de charge déclenchant automatiquement la charge de l'accumulateur quand le boîtier portable est disposé dans le logement du socle.

Avantageusement, le dispositif de gestion de charge peut déclencher la charge de l'accumulateur quand l'énergie électrique accumulée dans l'accumulateur est inférieure à un niveau bas prédéterminé.

De préférence, le dispositif de gestion de charge peut arrêter la charge de l'accumulateur quand l'énergie électrique accumulée dans l'accumulateur dépasse un niveau haut prédéterminé.

Par exemple, les moyens pour charger l'accumulateur peuvent comprendre un émetteur associé au socle et relié au secteur, et un récepteur disposé dans le boîtier portable et relié à l'accumulateur, l'émetteur générant un champ magnétique que le récepteur transforme en courant électrique.

Avantageusement, l'émetteur peut comprendre un oscillateur générant à partir du courant du secteur un courant à haute fréquence prédéterminée, et une bobine source alimentée par l'oscillateur et générant un champ magnétique, le récepteur comprenant une bobine réceptrice disposée dans le champ magnétique à proximité de la bobine source quand le boîtier portable est disposé dans le logement du socle, cette bobine réceptrice produisant sous l'effet de ce champ magnétique un courant alimentant l'accumulateur .

De préférence, la fréquence du courant produit par l'oscillateur peut être comprise entre 20 et 60 kiloHertz.

Par exemple, le boîtier portable peut être alimenté par des piles électriques amovibles remplaçant l'accumulateur comme source d'énergie électrique du boîtier portable.

Avantageusement, le boîtier portable peut comprendre un dispositif de détection des piles désactivant les moyens pour charger l'accumulateur quand les piles sont en place dans le boîtier portable.

De préférence, les piles électriques et l'accumulateur peuvent être disposés dans un même compartiment du boîtier portable, les piles électriques remplaçant l'accumulateur dans ce compartiment.

D'autres caractéristiques et avantages de l'invention ressortiront clairement de la description qui en est faite ci-dessous, à titre indicatif et nullement limitatif, en référence aux figures annexées, parmi lesquelles :
- la figure 1 est une vue en perspective de l'appareil selon l'invention,
- la figure 2 est une vue de profil suivant la flèche 2 de la figure 1, les bobines d'inductions étant représentées en pointillés,
- la figure 3 est une vue en coupe du boîtier portable suivant les flèches III de la figure 1, et
- la figure 4 est un schéma de principe, entre autres, de l'émetteur et du récepteur des moyens pour charger l'accumulateur de l'appareil de la figure 1.

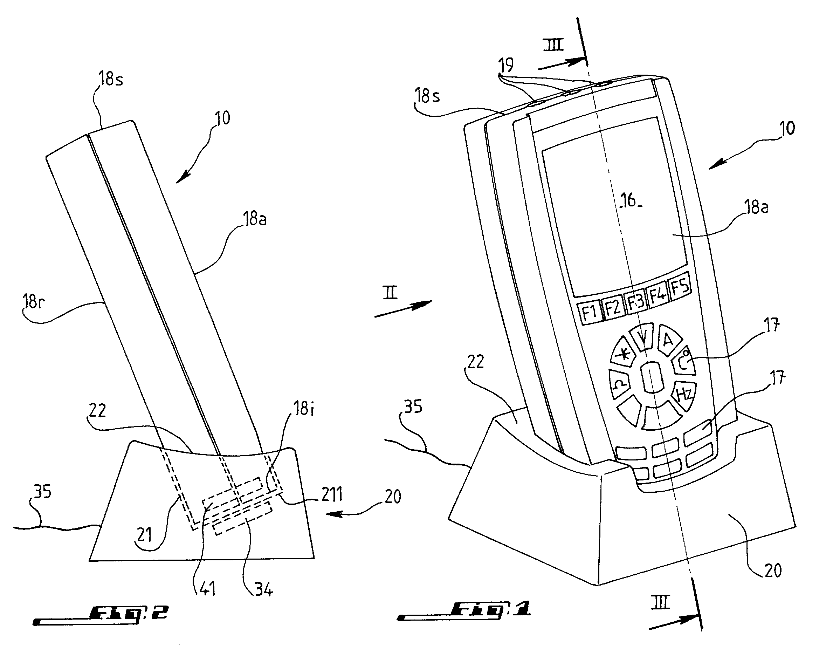

L'appareil multimètre de la figure 1 permet de mesurer une pluralité de grandeurs, telles que l'intensité, la tension ou la fréquence d'un courant électrique, la capacité ou la résistance électrique d'un circuit, ou encore la température.

Cet appareil comprend un boîtier portable 10 permettant à lui seul de réaliser les mesures attendues, muni d'un accumulateur d'énergie électrique 11 rechargeable qui alimente les différents organes du boîtier, comme par exemple des circuits de mesure, un écran de visualisation des résultats 16, ou un microprocesseur.

Après une certaine durée d'utilisation avec l'accumulateur 11 comme source d'énergie électrique, il est nécessaire de recharger celui-ci.

Selon l'invention, l'appareil comprend des moyens pour charger l'accumulateur 11 par induction.

Ces moyens rendent l'utilisation de l'appareil multimètre simple et agréable pour l'utilisateur, en particulier quand on considère une autre caractéristique avantageuse de l'invention, qui est que l'appareil comprend un socle 20 présentant un logement 21 de réception du boîtier portable 10, les moyens pour charger l'accumulateur comprenant un dispositif de gestion de charge 43 déclenchant automatiquement la charge de l'accumulateur 11 quand le boîtier portable 10 est disposé dans le logement 21 du socle 20 et quand l'énergie électrique accumulée dans l'accumulateur 11 est inférieure à un niveau bas prédéterminé.

Le dispositif de gestion de charge 43 arrête la charge de l'accumulateur 11 quand l'énergie électrique accumulée dans l'accumulateur 11 dépasse un niveau haut prédéterminé.

A cet effet, le dispositif de gestion de charge 43 mesure la tension aux bornes de l'accumulateur 11. Cette tension varie en fonction de la charge de l'accumulateur 11. Elle est faible quand l'accumulateur 11 est à son niveau de charge bas, augmente progressivement avec la charge, atteint un maximum quand la charge atteint le niveau haut et baisse si la charge dépasse le niveau haut. Le dispositif de gestion de charge 43 détecte le niveau haut en repérant le point d'inflexion de la tension.

Le socle 20 peut par exemple être posé sur un bureau ou un établi, l'utilisateur pouvant ainsi facilement laisser en permanence le boîtier portable 10 dans le logement 21 quand il ne l'utilise pas, à la manière d'un téléphone sans fil. Il est ainsi certain de ne jamais trouver l'accumulateur 11 déchargé.

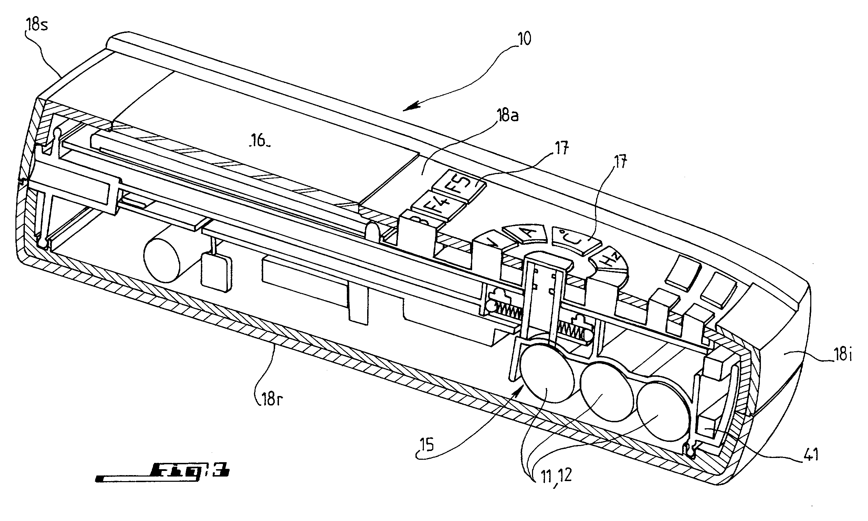

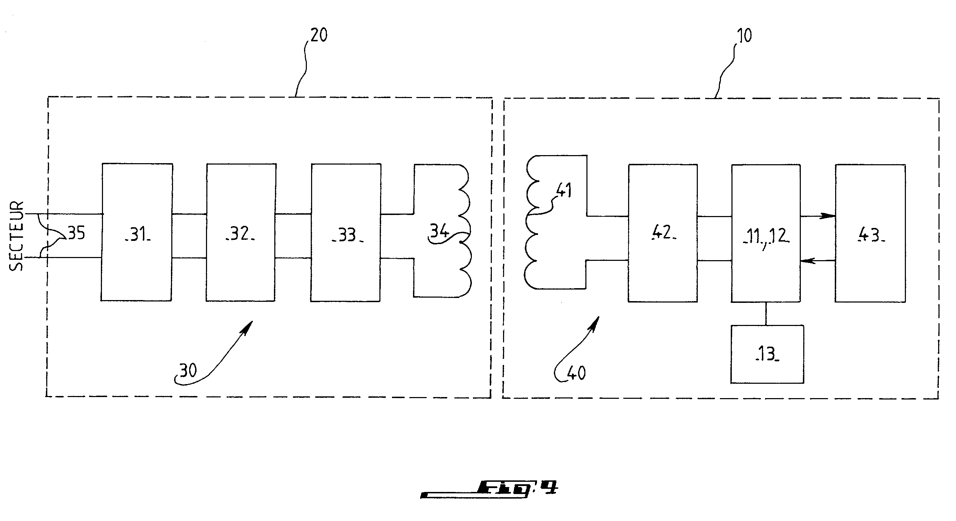

Comme le montre la figure 4, les moyens pour charger l'accumulateur 11 comprennent un émetteur 30 associé au socle 20 et relié au secteur, par exemple par un cordon d'alimentation 35, et un récepteur 40 disposé dans le boîtier portable 10 et relié à l'accumulateur 11. L'émetteur 30 est généralement disposé à l'intérieur du socle 20. L'émetteur 30 génère un champ magnétique que le récepteur 40 transforme en courant électrique et transmet à l'accumulateur 11.

L'émetteur 30 comprend un oscillateur 33 générant à partir du courant du secteur un courant à haute fréquence prédéterminée, et une bobine source 34 alimentée par l'oscillateur 33 et générant le champ magnétique.

Un dispositif de filtrage 31 et un premier dispositif de redressement filtrage 32 sont interposés dans cet ordre entre le secteur et l'oscillateur 33.

L'émetteur fonctionne à partir d'un courant secteur de tension 220 Volts et de fréquence 50 Hertz. Le dispositif de filtrage 31 permet d'éliminer les fréquences générées par l'oscillateur 33 et d'éviter ainsi de perturber le secteur par conduction. Il permet de respecter la norme 55022 concernant l'émission/conduite et la norme 61000-4-6 concernant l'immunité.

Le premier dispositif de redressement filtrage 32 permet de redresser et de filtrer le courant venant du secteur à travers le dispositif de filtrage 31 et de produire un courant continu qui alimente l'oscillateur 33, de tension et d'intensité adaptées à celui-ci.

L'oscillateur 33 produit un courant alternatif de fréquence comprise entre 20 et 60 kiloHertz, et de tension élevée, environ 300 Volts.

Le récepteur 40 comprenant une bobine réceptrice 41 disposée dans le champ magnétique à proximité de la bobine source 34 quand le boîtier portable 10 est disposé dans le logement 21 du socle 20. Cette bobine réceptrice 41 produit sous l'effet du champ magnétique un courant continu alimentant l'accumulateur 11 à travers un second dispositif de redressement filtrage 32.

Le courant produit par la bobine réceptrice 41 est de fréquence identique et de tension plus faible que le courant produit par l'oscillateur 33.

Le second dispositif de redressement filtrage 32, interposé entre la bobine réceptrice 41 et l'accumulateur 11, produit un courant continu de tension et d'intensité acceptable par l'accumulateur 11 à partir du courant fourni par la bobine réceptrice 41.

Le transfert d'énergie entre la bobine source 34 et la bobine réceptrice 41 s'effectue de la même façon que dans un transformateur électrique. Le couplage, donc le rendement du transfert, est d'autant meilleur que les bobines seront proches l'une de l'autre.

Les positions respectives de la bobine source 34 et de la bobine réceptrice 41 sont illustrées sur la figure 2 . Le boîtier portable 10 présente une forme proche d'un parallélépipède rectangle, comprenant une face avant 18a, une face arrière 18r opposée à la face avant 18a, et une tranche de faible épaisseur relativement aux dimensions des faces avant et arrière 18a et 18r. La tranche présente un côté supérieur 18s portant des douilles d'entrées 19, et un côté inférieur 18i opposé au côté supérieur 18s. La face avant 18a porte l'écran de visualisation 16 sur une zone proche du côté supérieur 18s, et des touches de commande 17 sur une zone proche du côté inférieur 18i. Le boîtier est allongé dans une direction longitudinale allant du côté inférieur 18i au côté supérieur 18s.

Comme le montre la figure 3, la bobine réceptrice 41 est disposée à l'intérieur du boîtier portable, dans un plan sensiblement parallèle au côté inférieur 18i et immédiatement à proximité de celui-ci.

Le boîtier portable 10 est engagé dans le logement 21 par une extrémité longitudinale inférieure se terminant par le côté inférieur 18i.

Le socle 20 présente une forme générale de cendrier, le logement 21 étant ménagé sur la face supérieure 22 du socle et présentant une forme correspondante à celle de l'extrémité inférieure du boîtier portable 10. Une fois engagé dans le logement, le boîtier portable 10 tient debout de façon autonome.

Le logement 21 comprend un fond 211 contre lequel vient s'appuyer le côté inférieur 18i du boîtier. La bobine source 34 est disposée à l'intérieur du socle 20, dans un plan parallèle à la bobine réceptrice 41 quand le boîtier portable 10 est engagé dans le logement 21, immédiatement à proximité du fond 211 de ce logement 21.

Le boîtier portable 10 peut également fonctionner avec des piles électriques amovibles 12, qui remplacent l'accumulateur 11 comme source d'énergie électrique du boîtier portable 10.

Les piles électriques 12 et l'accumulateur 11 sont disposés dans un même compartiment 15 du boîtier portable 10, les piles électriques 12 remplaçant l'accumulateur 11 dans ce compartiment 15 quand le boîtier portable fonctionne sur piles. Comme le montre la figure 3, ce compartiment 15 est situé à proximité de la bobine réceptrice 41. L'accumulateur 11 et les piles 12 peuvent être introduits et extraits du compartiment 15 par une ouverture pratiquée sur la tranche ou sur la face arrière du boîtier portable, normalement fermée par un volet pivotant ou amovible. L'ouverture et le volet ne sont pas représentés sur les figures 1 à 3.

Le boîtier portable 10 comprend un dispositif de détection des piles 13 désactivant les moyens pour charger l'accumulateur 11 quand les piles 12 sont en place dans le compartiment 15 du boîtier portable 10.

Le boîtier portable 10 peut également fonctionner directement à partir du courant du secteur, à la condition que le boîtier soit engagé dans le logement 21 du socle 20. Dans ce mode de fonctionnement, l'accumulateur 11 peut indifféremment être présent ou non dans le compartiment 15 du boîtier. De même, les piles électriques 12 peuvent indifféremment être présentes ou non dans le compartiment 15 du boîtier.

Le socle 20 joue un rôle d'interface de communication vis-à-vis du boîtier portable 10. Le boîtier portable 10 et le socle 20 peuvent communiquer par une liaison optique (non représentée) quand le boîtier est engagé dans le logement 21, et le socle 20 est muni d'un port du type connu sous le sigle RS232 et d'un câble adapté permettant de relier ce port RS232 à un ordinateur ou une imprimante. Les informations stockées dans le boîtier portable 10 peuvent ainsi être directement imprimées ou transférées dans la mémoire de l'ordinateur.

On notera, comme le montre les figures 1 et 2, que le boîtier portable 10 est dans une position légèrement incliné par rapport à la verticale quand il est engagé dans le logement 21 du socle 20, et que les touches 17 restent accessibles, ce qui permet à l'utilisateur d'accéder facilement à ces touches pour commander le transfert ou l'impression des données, ou pour effectuer toute autre opération sur le boîtier.

On comprend donc bien que l'appareil offre la commodité d'utilisation d'un multimètre rechargeable par un branchement direct sur secteur, sans en présenter les défauts.

Les appareils rechargeables directement sur secteur, c'est-à-dire sans retirer l'accumulateur du boîtier, comprennent généralement une douille dans laquelle vient s'engager un cordon de raccordement au secteur.

Cette douille est un point faible pour l'étanchéité du multimètre à l'eau et à la poussière.

Par ailleurs, il est nécessaire de garantir une isolation totale entre les circuits de mesure et l'alimentation électrique. Cette isolation est obtenue, dans un appareil rechargeable directement sur secteur, en prévoyant un transformateur d'isolement dans le boîtier portable, interposé par exemple entre la douille de raccordement au secteur et l'accumulateur. Ce transformateur n'est plus nécessaire dans l'appareil de l'invention car il n'y a pas de liaison matérielle entre le secteur et l'accumulateur, les bobines d'induction étant matériellement isolées l'une de l'autre.

Enfin, les normes de sécurité électrique imposent pour les appareils multimètres une double isolation pour protéger l'utilisateur. Cette imposition se traduit par des contraintes de distances minimum entre la douille de raccordement au secteur et d'autres éléments de l'appareil, qui peuvent être gênantes. L'appareil de l'invention est affranchi de ces contraintes car il ne comprend pas de douille de raccordement au secteur.

On notera également que l'appareil peut être conçu sans la possibilité de fonctionner avec des piles électriques. Le compartiment recevant l'accumulateur peut alors être entièrement fermé, sans volet d'ouverture, ce qui permet d'accroître l'étanchéité du boîtier portable.

Bien entendu, le socle et le boîtier portable peuvent présenter des formes générales différentes de celles décrites ci-dessus sans sortir du cadre de l'invention.

## Revendications

1. Appareil multimètre de mesure d'une pluralité de grandeurs, telles que l'intensité ou la tension d'un courant électrique ou la résistance électrique d'un circuit, comprenant un boîtier portable (10) muni d'un accumulateur d'énergie électrique (11) rechargeable, des moyens pour charger l'accumulateur (11) par induction, et un socle (20) présentant un logement (21) de réception du boîtier portable, **caractérisé en ce que** les moyens pour charger l'accumulateur (11) comprennent un dispositif de gestion de charge (43) déclenchant automatiquement la charge de l'accumulateur (11) quand le boîtier portable (10) est disposé dans le logement (21) du socle (20) et que l'énergie électrique accumulée dans l'accumulateur (11) est inférieure à un niveau bas prédéterminé.

2. Appareil selon la revendication 1, **caractérisé en ce que** le dispositif de gestion de charge (43) arrête la charge de l'accumulateur (11) quand l'énergie électrique accumulée dans l'accumulateur (11) dépasse un niveau haut prédéterminé.

3. Appareil selon l'une quelconque des revendications 1 à 2, **caractérisé en ce que** les moyens pour charger l'accumulateur (11) comprennent un émetteur (30) associé au socle (20) et relié au secteur, et un récepteur (40) disposé dans le boîtier portable (10) et relié à l'accumulateur (11), l'émetteur (30) générant un champ magnétique que le récepteur (40) transforme en courant électrique .

4. Appareil selon la revendication 3, **caractérisé en ce que** l'émetteur (30) comprend un oscillateur (33) générant à partir du courant du secteur un courant à haute fréquence prédéterminée, et une bobine source (34) alimentée par l'oscillateur (33) et générant un champ magnétique, le récepteur (40) comprenant une bobine réceptrice (41) disposée dans le champ magnétique à proximité de la bobine source (34) quand le boîtier portable (10) est disposé dans le logement (21) du socle (20), cette bobine réceptrice (41) produisant sous l'effet de ce champ magnétique un courant alimentant l'accumulateur (11) .

5. Appareil selon la revendication 4, **caractérisé en ce que** la fréquence du courant produit par l'oscillateur (33) est comprise entre 20 et 60 kiloHertz.

6. Appareil selon l'une quelconque des revendications 1 à 5, **caractérisé en ce que** le boîtier portable (10) peut être alimenté par des piles électriques (12) amovibles remplaçant l'accumulateur (11) comme source d'énergie électrique du boîtier portable (10) .

7. Appareil selon la revendication 6, **caractérisé en ce que** le boîtier portable (10) comprend un dispositif de détection des piles (13) désactivant les moyens pour charger l'accumulateur (11) quand les piles (12) sont en place dans le boîtier portable (10).

8. Appareil selon la revendication 6 ou 7, **caractérisé en ce que** les piles électriques (12) et l'accumulateur (11) sont disposés dans un même compartiment (15) du boîtier portable (10), les piles électriques (12) remplaçant l'accumulateur (11) dans ce compartiment (15).
